# EUROPÄISCHE PATENTSCHRIFT

(11) **EP 2 041 871 B1**
(45) Veröffentlichungstag und Bekanntmachung des Hinweises auf die Patenterteilung: **02.03.2011**
(21) Anmeldenummer: 07765034.9
(22) Anmeldetag: 03.07.2007
(51) Int. Cl.: H03K 17/95

(54) **VERFAHREN UND VORRICHTUNG ZUR SICHEREN ABSTANDSÜBERWACHUNG**
METHOD AND DEVICE FOR SECURE SEPARATION MONITORING
PROCÉDÉ ET DISPOSITIF PERMETTANT DE SURVEILLER UNE DISTANCE EN TOUTE SÉCURITÉ

(30) Priorität: 07.07.2006 DE 102006032226
(43) Veröffentlichungstag der Anmeldung: 01.04.2009
(73) Patentinhaber: Pilz GmbH & Co. KG, 73760 Ostfildern (DE)
(72) Erfinder: HECHINGER, Martin, 79336 Herbolzheim (DE)
(74) Vertreter: Duhme, Torsten
(86) Internationale Anmeldenummer: PCT/EP2007/005894
(87) Internationale Veröffentlichungsnummer: WO 2008/003469

(56) Entgegenhaltungen:
- EP-A- 0 393 359
- EP-A- 1 289 147
- DE-A1- 4 212 363

## Beschreibung

Die vorliegende Erfindung betrifft ein Verfahren zum sicheren Überwachen eines Abstands eines metallischen Teils relativ zu einem induktiven Näherungssensor, insbesondere zum Überwachen einer Schließposition einer Schutztür an einer automatisierten Anlage.

Die Erfindung betrifft ferner eine Signalisiervorrichtung zum sicheren Überwachen eines Abstands eines metallischen Teils relativ zu einem induktiven Näherungssensor, insbesondere zum Überwachen einer Schließposition einer Schutztür an einer automatisierten Anlage.

Zur Absicherung eines Gefahrenbereichs einer automatisiert arbeitenden Anlage, wie beispielsweise automatisiert arbeitenden Robotern, Pressen oder Transportbändern, sind häufig Schutztüren vorgesehen, die einen Kontakt des Bedieners mit solchen Teilen der Anlage verhindern, die für den Bediener eine Gefahr darstellen können. Damit die Schutztür ihre Schutzfunktion wahrnehmen kann, muss vor Inbetriebnahme der Anlage geprüft werden, ob die Schutztür ordnungsgemäß geschlossen ist. Zu diesem Zweck kann man einen induktiven Näherungssensor der nachfolgend beschriebenen Art verwenden, der überprüft, ob sich die Schutztür in einer bestimmten Position befindet. Solange die erforderliche Position der Schutztür nicht erreicht ist, kann die Anlage nicht eingeschaltet werden.

Der induktive Näherungssensor funktioniert nach dem folgenden Prinzip. In dem Näherungssensor befindet sich ein Schwingkreis, der mittels eines Impulses zum Schwingen angeregt wird. Der Schwingkreis weist eine charakteristische abklingende Schwingung auf, wenn sich ein zu detektierendes Metall nicht in seiner Nähe befindet. Wird nun das Metall dem Näherungssensor angenähert, so ändert sich die Dämpfung und/oder Frequenz der abklingenden Schwingung.

Schwierigkeiten bereitet hierbei allerdings, dass das zu detektierende Metall im Vorfeld bekannt sein muss und der Näherungssensor entsprechend aufgebaut sein muss. Soll beispielsweise ein bestimmter Abstand sowohl für Aluminium (nichtferromagnetisch) als auch für Eisen (ferromagnetisch) erkannt werden, so ist entweder eine Umkonfiguration oder eine sehr aufwändige Einrichtung zur Materialerkennung erforderlich. Erst nach Kenntnis des Materials kann dann der Abstand bestimmt werden. Doch selbst bei einer Materialerkennung, die zwischen ferromagnetischen und nicht-ferromagnetischen Materialien unterscheiden kann, verbleiben Probleme bei Metalllegierungen, die sowohl ferromagnetische als auch nicht-ferromagnetische Anteile aufweisen.

In der Praxis hat sich außerdem gezeigt, dass das Öffnen und Schließen der Schutztür, beispielsweise um ein Werkstück einzuspannen, von einigen Bedienern als hinderlich empfunden wird. In der Vergangenheit ist es daher vorgekommen, dass Bediener die Sicherheitseinrichtung manipuliert haben, indem sie ein Stück Metall unmittelbar am Näherungssensor fixiert haben. In diesem Fall ließ sich die Anlage auch bei geöffneter Schutztür betreiben, da der Sensor das Metallstück fälschlicherweise als geschlossene Schutztür erkannte.

Um solchen Manipulationsversuchen entgegenzuwirken ist es wünschenswert, den relativen Abstand eines Näherungssensors zu einem metallischen Gegenstück so zu bestimmen oder zu überwachen, dass die Anlage auch dann nicht einschaltet bzw. abgeschaltet wird, wenn der Abstand des zu detektierenden Metalls zu gering ist.

Aus der DE 102 22 186 C1 ist ein Sicherheitsschalter bekannt, der zwei Sende/Empfangselemente aufweist. Dabei wird das eine Element beispielsweise ortsfest angebracht, während das andere Element an einer Schutztür befestigt wird. In einem ersten Schritt sendet das erste Element elektromagnetische Signale an das zweite Element, welches als LC-Schwingkreis ausgeführt ist. Dadurch wird das zweite Element zum Schwingen angeregt und speichert einen von seiner Entfernung zum ersten Element abhängigen Teil der gesendeten Energiemenge. Die so gespeicherte Energie wird anschließend in Form elektromagnetischer Wellen mit der Frequenz des LC-Schwingkreises des zweiten Elements abgestrahlt. Ein wiederum vom Abstand zwischen den beiden Elementen abhängiger Teil dieser Energie wird anschließend zum ersten Element zurückgesendet. Mittels Integration über einen vorbestimmten Zeitraum ergibt sich beim ersten Element eine Energiemenge, die ein Maß für den Abstand zwischen den beiden Elementen ist. Weicht die empfangene Energiemenge von einer erwarteten Energiemenge ab, so wird ein Zustand angenommen, bei dem ein Betrieb der entsprechenden Anlage nicht erlaubt ist.

Aus der EP 1 278 077 A2 ist das allgemeine Prinzip eines induktiven Näherungssensors bekannt, der nicht auf ein entsprechend ausgebildetes Gegenstück (Sende/Empfangselement) angewiesen ist. Der Sensor weist aber nicht den für einen Einsatz in der Sicherheitstechnik erforderlichen Manipulationsschutz auf.

Aus EP 1 289 147 ist eine fremderregte Näherungs- oder Anwesenheitsschalteranordnung bekannt, bei der die Änderung einer oder mehrerer Parameter aus der Gruppe von Abklingzeitkonstante, Frequenz, maximale Amplitude und Phase mit einer Referenzschwingung oder Referenzwerten verglichen werden sollen aber es gibt keinen Hinweis auf die besondere Kombination der auszuwertenden Parameter.

Aus DE 42 12 363 ist ein Metalldetektor bekannt, der nach dem Dämpfungsprinzip arbeitet und zusätzlich zu einer Suchoszillator-Amplitudenauswertung auch eine Suchoszillator-Frequenzauswertung vornimmt. Obwohl bleibt offen, in welcher Weise man die Amplitude und die Frequenz auswerten müssen, um bessere Information über Objektlage, Objektgröße un Objektmaterial zu erhalten.

Vor diesem Hintergrund ist es eine Aufgabe der vorliegenden Erfindung, eine kostengünstige Vorrichtung und ein Verfahren zum sicheren Überwachen eines Abstands eines metallischen Teils relativ zu einem induktiven Näherungssensor aufzuzeigen, auch wenn die Annäherung verschiedener Metalle zu berücksichtigen ist. Dabei soll insbesondere ein Manipulationsschutz realisierbar sein, der die Einhaltung eines Mindestabstands sicherstellt und einen gleichen Mindestabstand für verschiedene Metalle ermöglicht.

Diese Aufgabe wird nach einem Aspekt der Erfindung mit einem Verfahren nach Anspruch 1 gelöst. nach Anspruch 9.

Eine Besonderheit der Erfindung ist darin zu sehen, dass sich trotz der unterschiedlichen Charakteristiken von ferromagnetischen und nicht-ferromagnetischen Materialien, sowie von Mischungen dieser Materialien, auf einfache Weise ein Manipulationsschutz realisieren lässt.

Die Erfindung beinhaltet, dass sowohl die Ist-Frequenz der abklingenden Schwingung mit einer vorgegebenen Maximalfrequenz verglichen wird, als auch die Ist-Dämpfung mit einer vorgegebenen Maximaldämpfung. Damit kann der erforderliche Mindestabstand eines Metalls zum Schwingkreis, insbesondere dem Schwingkreis eines Näherungssensors, detektiert werden.

Wenngleich die Erfindung weiterhin die Möglichkeit bietet, die Art des angenäherten Metalls zu erkennen und auch einen numerischen Abstandswert zu liefern, kann der als Manipulationsschutz wirkende Mindestabstand auch ohne konkrete Kenntnis dieser Informationen überwacht werden.

Dies basiert auf der Erkenntnis, dass eine Überprüfung der Ist-Frequenz und der Ist-Dämpfung auf einfache Weise sowohl einen Manipulationsschutz für ferromagnetische als auch für nicht-ferromagnetische Metalle ermöglicht. Dies gilt auch für eine Vielzahl von Metallen, die eine Mischung von ferromagnetischen und nicht-ferromagnetischen Anteilen aufweisen. Das Prinzip dieses Vorgehens wird anhand der Ausführungsbeispiele näher erläutert.

Neben dem erläuterten Anwendungsfall bei einer Schutztür können ein entsprechendes Verfahren und eine entsprechende Vorrichtung auch bei einer Presse vorteilhaft eingesetzt werden. Soll die Aktivierung einer Presse nur aus einer bestimmten Position heraus möglich sein, so kann in der zuvor beschriebenen Art festgestellt werden, ob die für den Betrieb erforderliche Position gegeben ist. So kann beispielsweise detektiert werden, ob eine Stellnocke, die dem Antrieb der Presse zugeordnet ist, eine bestimmte Position hat oder innerhalb eines bestimmten Winkelbereichs steht. Nur in diesem Fall wird die Presse für den Betrieb freigeschaltet.

Damit ist die oben genannte Aufgabe vollständig gelöst.

In einer Ausgestaltung der Erfindung wird signalisiert, ob die Ist-Frequenz eine vorgegebene Minimalfrequenz und/oder die Ist-Dämpfung auch eine vorgegebene Minimaldämpfung über schreitet.

Auf diese Weise kann neben dem benötigen Manipulationsschutz auch die Überwachung realisiert werden, ob sich das metallische Teil ausreichend nah am Schwingkreis befindet. Für den Anwendungsfall der Schutztür bedeutet dies, dass eine geschlossene bzw. eine offene Schutztür erkannt werden, wobei aber gleichzeitig die Manipulation durch ein auf den Näherungssensor aufgebrachtes Metallteil erkannt wird. Gleiches gilt für den Anwendungsfall der Stellnocke, wobei auch hier festgestellt werden kann, ob sich tatsächlich die Nocke in der Nähe des Näherungssensor befindet oder aber ein aufliegendes Metallteil detektiert wird.

Das Signalisieren kann dabei auf verschiedene Weisen erfolgen. So ist es einerseits möglich, das Überschreiten der Minimalfrequenz bzw. der Minimaldämpfung unabhängig vom Unterschreiten der Maximalfrequenz und der Maximaldämpfung anzuzeigen, beispielsweise über das Senden von zwei oder drei Bits. Es ist aber ebenso ein kombiniertes Signalisieren möglich. Dabei wird dann insgesamt angezeigt, ob die Ist-Frequenz eine vorgegebene Maximalfrequenz unterschreitet, die Ist-Dämpfung eine vorgegebene Maximaldämpfung unterschreitet, und ob die Ist-Frequenz eine vorgegebene Minimalfrequenz überschreitet und/oder die Ist-Dämpfung eine vorgegebene Minimaldämpfung überschreitet. Ein solches kombiniertes Signal ist in vielen Anwendungen ausreichend, da es für ein Nicht-Einschalten bzw. ein Abschalten einer Anlage ausreichend sein kann zu wissen, dass eine der geforderten Sicherheitsbedingungen verletzt ist, wobei es aber zunächst unerheblich sein kann, welche konkrete Sicherheitsbedingung verletzt ist.

In einer weiteren Ausgestaltung der Erfindung, die auch für sich genommen eine erfinderische Weiterbildung des bekannten Verfahrens bzw. der bekannten Vorrichtung ist, wird ein Datensatz bereitgestellt, der einen ersten Zusammenhang zwischen der Frequenz und der Dämpfung bei Annäherung des metallischen Teils repräsentiert, und das Signalisieren zeigt an, ob die Ist-Frequenz und die Ist-Dämpfung dem ersten Zusammenhang entsprechen.

Dieser Ausführungsform, die auch ohne einen Vergleich mit einer Maximalfrequenz und mit einer Maximaldämpfung funktionstüchtig ist, liegt die Erkenntnis zugrunde, dass metallische Teile aus unterschiedlichen Materialien unterschiedliche Frequenz-Dämpfungs-Charakteristiken aufweisen. So ändert sich beispielsweise die Frequenz des Schwingkreises kaum, wenn Eisenstahl (ST37) an den Schwingkreis angenähert wird, während sich die Dämpfung bei der Annäherung deutlich verändert. Bei rostfreiem Stahl (V2A), der ein weiteres Beispiel darstellt, liegt im Vergleich zum Eisenstahl bei der Annäherung eine ähnliche Veränderung der Dämpfung vor, während sich nun zusätzlich eine Änderung der Frequenz einstellt. Damit ist die Frequenz-Dämpfungs-Charakteristik von rostfreiem Stahl deutlich unterschiedlich von der Charakteristik von Eisenstahl. Als weiteres Beispiel sei schließlich Kupfer (Cu) genannt, das bei einer Annäherung an den Schwingkreis zwar zu einer weniger starken Dämpfung führt, jedoch zu einer größeren Frequenzänderung. Damit unterscheidet sich die Frequenz-Dämpfungs-Charakteristik von Kupfer wiederum von den Charakteristiken von rostfreiem Stahl und Eisenstahl.

Ein solcher Zusammenhang zwischen der Frequenz und der Dämpfung bei Annäherung eines metallischen Teils aus einem bestimmten Material wird in einem Datensatz bereitgestellt. Ein solcher Datensatz umfasst im einfachsten Fall einen Frequenz-Dämpfungs-Datenpunkt oder die Beschreibung einer Geraden, aus der sich verschiedene Frequenz-Dämpfungs-Punkte bestimmen lassen. Es können aber auch komplexere Funktionen oder mittels Stützwerten beschriebene Kennlinien zur Beschreibung des Zusammenhangs zwischen der Frequenz und der Dämpfung verwendet werden. Die im Datensatz bereitgestellten Daten können dabei experimentell und/oder rechnerisch bestimmt werden.

Bei der Durchführung des Verfahrens, wenn nun ein Objekt an den Näherungssensor angenähert wird, wird für die Schwingung des Schwingkreises eine Ist-Frequenz und eine Ist-Dämpfung ermittelt, und es wird signalisiert, ob die Ist-Frequenz und die Ist-Dämpfung dem im Datensatz hinterlegten Zusammenhang entsprechen. Wird eine Entsprechung festgestellt, so erlaubt dies den Rückschluss, dass das Material, dessen Charakteristik im Datensatz bereitgestellt ist, an den Näherungssensor angenähert wird.

Aufgrund der Erkenntnis, dass sich die Frequenz-Dämpfungs-Charakteristiken der verschiedenen Materialien erkennbar unterscheiden, kann diese Feststellung weitestgehend unabhängig vom Abstand getroffen werden. (Lediglich bei einem großen Abstand ist eine sichere Unterscheidung schwierig. Dies ist für die bevorzugten Anwendungen jedoch unbeachtlich, da ein großer Abstand ohnehin einen unsicheren Zustand, zum Beispiel Schutztür geöffnet, anzeigt.)

Ob die Ist-Frequenz und die Ist-Dämpfung dem hinterlegten Zusammenhang entspricht, kann auf verschiedene Weisen überprüft werden. So kann beispielsweise definiert werden, dass ein von Ist-Frequenz und Ist-Dämpfung gebildetes Zweier-Tupel maximal um einen bestimmten Betrag von dem bereitgestellten Zusammenhang zwischen der Frequenz und der Dämpfung abweichen darf. Ist der Zusammenhang beispielsweise als Gerade oder Kennlinie hinterlegt, so kann mittels bekannter mathematischer Verfahren der Abstand des Zweier-Tupels zur Geraden bzw. zur Kennlinie ermittelt werden. Unterschreitet der errechnete Abstand den definierten Maximalwert, so wird dies dahingehend verstanden, dass die Ist-Frequenz und die Ist-Dämpfung dem Zusammenhang entsprechen. Falls der Abstand größer als der Maximalwert ist, so bedeutet dies, dass sie nicht dem Zusammenhang entsprechen.

In einer weiteren Ausgestaltung der Erfindung beschreibt der Datensatz einen von Frequenz und Dämpfung abhängigen Abstand zwischen dem metallischen Teil und dem Schwingkreis und wird ein Abstandswert in Abhängigkeit von Ist-Frequenz und Ist-Dämpfung bestimmt.

Dem liegt die Erkenntnis zugrunde, dass ein bestimmter Frequenz-Dämpfungs-Wert (Zweier-Tupel aus Frequenz und Dämpfung) auch einen unmittelbaren Rückschluss auf den Abstandswert des metallischen Teils zum Näherungssensor ermöglicht. Zwar kann aus dem Frequenz-Dämpfungs-Wert auch ein Rückschluss auf das Material des angenäherten Objekts gezogen werden, doch ist es aufgrund der unterschiedlichen Frequenz-Dämpfungs-Charakteristiken möglich, einen Abstandswert zu bestimmen, ohne dafür eine Materialinformation auswerten zu müssen. Bei Kenntnis von Ist-Frequenz und Ist-Dämpfung kann demnach unmittelbar ein Abstandswert bestimmt werden.

Die Bestimmung des Abstandswerts findet derart statt, dass zu gegebener Ist-Frequenz und Ist-Dämpfung der entsprechende Abstand im Datensatz ermittelt wird. Dies kann beispielsweise wieder derart erfolgen, dass der Wert des Datensatzes verwendet wird, der im mathematischen Sinne den geringsten Abstand zu dem gemessenen Zweier-Tupel hat.

Als eine weitere Alternative ist es möglich, die zwei nächstliegenden Werte zu bestimmen und den Abstandswert zwischen diesen beiden Werten zu interpolieren oder extrapolieren. Auch auf diese Weise kann unmittelbar einem gemessenen Zweier-Tupel aus Ist-Frequenz und Ist-Dämpfung ein Abstandswert zugeordnet werden.

In einer weiteren Ausgestaltung der Erfindung wird signalisiert, ob der Abstandswert einen Mindestabstandswert überschreitet und/oder einen Maximalabstandswert unterschreitet.

Durch Berücksichtigung eines Mindestabstandswerts kann der Manipulationsschutz und/oder durch Berücksichtigung eines Maximalabstandswerts die Feststellung einer ausreichenden Nähe des metallischen Teils realisiert werden.

In einer weiteren Ausgestaltung der Erfindung repräsentiert der Datensatz einen zweiten Zusammenhang zwischen der Frequenz und der Dämpfung bei Annäherung eines metallischen Teils aus einem vom ersten Material verschiedenen, zweiten Material an den Schwingkreis und es wird signalisiert, ob die Ist-Frequenz und die Ist-Dämpfung dem zweiten Zusammenhang entsprechen.

Zu dieser Ausführungsform gelten die obigen Ausführungen entsprechend. Die Hinterlegung eines zweiten Zusammenhangs ermöglicht es aber nun, mindestens drei Zustände zu erkennen:
a) es wird ein Objekt angenähert, das dem ersten Zusammenhang und damit dem ersten Material entspricht;
b) es wird ein Objekt angenähert, das dem zweiten Zusammenhang und damit dem zweiten Material entspricht;
c) es wird ein Material angenähert, das weder dem ersten noch dem zweiten Zusammenhang und damit weder dem ersten noch dem zweiten Material entspricht.

Hinsichtlich der Art der Realisierung ergeben sich auch hier wieder viele Möglichkeiten. So können die ermittelten Informationen jeweils einzeln signalisiert werden, in Gruppen signalisiert werden, wobei jede Gruppe auch logische Verknüpfungen verschiedener Informationen enthalten kann, oder aber in der Form eines Gesamtsignals ausgegeben werden. So kann das Gesamtsignal beispielsweise anzeigen, ob neben dem Einhalten der vorgegebenen Minimal-/Maximalwerte außerdem die Bedingung erfüllt ist, dass das angenäherte Objekt entweder aus dem ersten Material oder aus dem zweiten Material besteht.

Oder es kann beispielsweise bei Erfüllung aller Bedingungen ein Signal auf einem ersten Pegel ausgegeben werden, während bei Nichterfüllung zumindest einer der

Bedingungen ein Signal auf einem zweiten Pegel ausgegeben wird. Dies ist für die Sicherheitstechnik vorteilhaft, da dann auf einfache Weise signalisiert werden kann, ob alle sicherheitsrelevanten Bedingungen für den Betrieb der Anlage erfüllt sind oder nicht.

In einer weiteren Ausgestaltung der Erfindung wird signalisiert, welchem der im Datensatz hinterlegten Zusammenhänge die Ist-Frequenz und die Ist-Dämpfung entsprechen.

Dadurch kann zusätzlich die Information bereitgestellt werden, aus welchem Material das Objekt besteht bzw. welches Material das Objekt überwiegend aufweist, das dem Näherungssensor angenähert wird.

Das Material kann dabei derart bestimmt werden, indem geprüft wird, welchem der im Datensatz hinterlegten Zusammenhänge das Zweier-Tupel aus Ist-Frequenz und Ist-Dämpfung am besten entspricht. Eine Entsprechung kann dabei wie zuvor beschrieben ermittelt werden, beispielsweise zu welchem Zusammenhang das Zweier-Tupel den geringsten Abstand hat. Weitere Abfragen, beispielsweise ob das Zweier-Tupel einen maximal erlaubten Abstand zum nächstliegenden Zusammenhang überschreitet, können zusätzlich implementiert werden, so dass auch eine Fehlerbehandlung möglich ist.

In einer weiteren Ausgestaltung der Erfindung ist im Datensatz mindestens ein weiterer Zusammenhang für ein weiteres Material hinterlegt und wird signalisiert, ob die Ist-Frequenz und die Ist-Dämpfung einen Zusammenhang aus einer bestimmten Gruppe von Zusammenhängen entsprechen.

Auf diese Weise kann beispielsweise eine Gruppe von Materialien definiert werden, die eine bestimmte Signalisierung hervorrufen sollen. So können beispielsweise die Zusammenhänge für Eisenstahl, rostfreien Stahl, Aluminium (Al) und Kupfer hinterlegt werden, wobei eine Gruppe aus Eisenstahl und Kupfer sowie eine Gruppe aus rostfreiem Stahl und Aluminium definiert werden. Bei der vorgeschlagenen Ausführungsform kann dann unter anderem signalisiert werden, ob das Zweier-Tupel der Gruppe von rostfreiem Stahl und Aluminium entspricht, ob es sich also bei dem Material eines angenäherten Objekts um rostfreien Stahl oder Aluminium handelt.

In einer weiteren Ausgestaltung der Erfindung wird das Verfahren doppelt ausgeführt und es wird bei einem Abweichen in der jeweils resultierenden Signalisierung ein Fehler signalisiert.

Um die Wahrscheinlichkeit zu verringern, dass durch einen Fehler beim Durchführen des Verfahrens oder durch einen Fehler in der Signalisiervorrichtung eine Anlage zum Betrieb freigeschaltet wird, obwohl die sicherheitsrelevanten Bedingungen nicht erfüllt sind, ist es vorteilhaft, das Verfahren bzw. die Signalisiervorrichtung durch eine Redundanz abzusichern. Dies kann beispielsweise dadurch erreicht werden, dass das Verfahren zeitlich eng beabstandet zweimal durchlaufen wird.

Bevorzugt ist es jedoch, das Verfahren in zwei verschiedenen, im Wesentlichen gleich aufgebauten Teilen der Signalisiervorrichtung durchzuführen. Dabei wird davon ausgegangen, dass die erste Durchführung des Verfahrens (im ersten Teil der Vorrichtung) und die zweite Durchführung des Verfahrens (im zweiten Teil der Vorrichtung) zu demselben Ergebnis führen müssen.

Das Ergebnis des ersten Signalgebers und des zweiten Signalgebers wird dann an eine Vergleichseinheit geleitet, die die beiden Ergebnissignale vergleicht. Stimmen die Ergebnissignale nicht überein, so wird eine Fehlfunktion angenommen und ein Fehler signalisiert.

Der Fehler kann als getrenntes Signal angezeigt werden, aber auch als kombiniertes Signal. So kann beispielsweise mittels eines Signals auf einem ersten Pegel angezeigt werden, dass alle sicherheitsrelevanten Bedingungen erfüllt sind und dass kein Fehler vorliegt, während mit einem Signal auf einem zweiten Pegel angezeigt wird, dass mindestens eine der sicherheitsrelevanten Bedingungen nicht erfüllt ist oder dass ein Fehler vorliegt. Dadurch kann auf einfache Weise die Freigabe bzw. die Nicht-Freigabe der Anlage signalisiert werden.

Es versteht sich, dass die vorstehend genannten und die nachstehend noch zu erläuternden Merkmale nicht nur in der jeweils angegebenen Kombination, sondern auch in anderen Kombinationen oder in Alleinstellung verwendbar sind, ohne den Rahmen der vorliegenden Erfindung zu verlassen.

Ausführungsbeispiele der Erfindung sind in der Zeichnung dargestellt und werden in der nachfolgenden Beschreibung näher erläutert. Es zeigen:
- Figur 1: einen Aufbau mit einer erfindungsgemäßen Signalisiervorrichtung;
- Figur 2: eine zweikanalige Signalisiervorrichtung, die an eine Steuereinheit angeschlossen ist;
- Figur 3: den Ablauf eines erfindungsgemäßen Verfahrens in der Darstellung eines Flussdiagramms;
- Figur 4: Frequenz-Dämpfungs-Charakteristiken mit zugeordneten Abstandswer- ten für verschiedene Materialien;
- Figur 5: die Darstellung gemäß Figur 4 mit eingezeichneten Minimal- und Maximalwerten; und
- Figur 6: die Darstellung gemäß Figur 4 mit dedizierten erlaubten Bereichen.

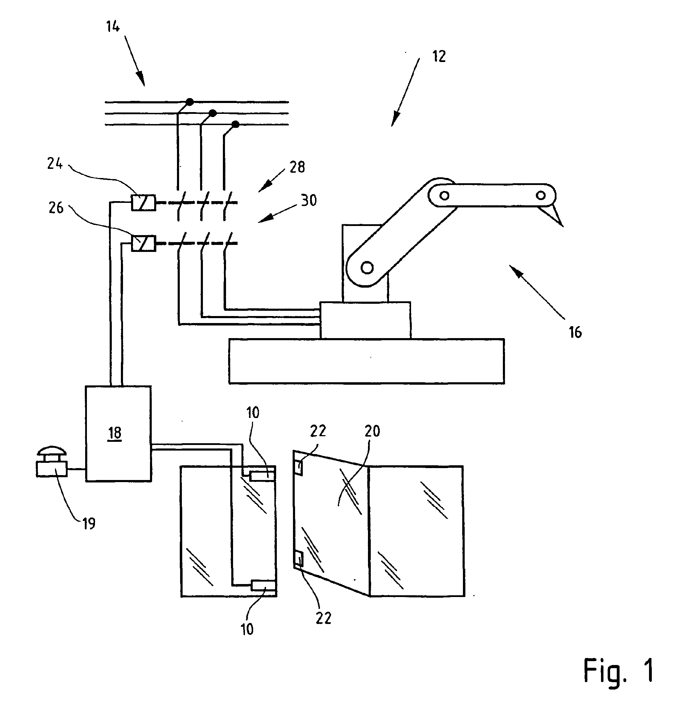

In Figur 1 ist ein Aufbau mit der neuen Signalisiervorrichtung 10 in seiner Gesamtheit mit der Bezugsziffer 12 bezeichnet. Der Aufbau 12 beinhaltet hier eine Stromversorgung 14, eine Maschine 16 und zwei Signalisiervorrichtungen 10, die an eine Steuereinheit 18 angeschlossen sind. Die Signalisiervorrichtungen 10 sind hier gemäß dem Prinzip eines induktiven Näherungssensors aufgebaut. Grundsätzlich ist es ausreichend, eine Signalisiervorrichtung 10 zu verwenden.

Die Maschine 16 darf nur dann eingeschaltet werden, wenn von beiden Signalisiervorrichtungen 10 eine Freigabe signalisiert wird. Die Signalisiervorrichtungen 10 zeigen an, ob jedes der metallischen Teile 22, die an der Schutztür 20 angeordnet sind, sich in einem definierten Abstandsbereich zu ihrer jeweils zugeordneten Signalisiervorrichtung 10 befinden. Dabei wird hier sowohl überwacht, dass die metallischen Teile 22 einen Mindestabstand zur jeweiligen Signalisiervorrichtung 10 einhalten, aber gleichzeitig auch einen bestimmten Maximalabstand nicht überschreiten. Selbstverständlich kann eine metallische Schutztür 20 auch selbst die Funktion der metallischen Teile 22 erfüllen, so dass keine separaten Teile 22 benötigt werden.

Wenn beide Signalisiervorrichtungen 10 das korrekte Schließen der Schutztür 20 und damit die Möglichkeit der zulässigen Inbetriebnahme der Maschine 16 anzeigen, steuert die Steuereinheit 18 zwei Schütze 24, 26 an, deren Arbeitskontakte 28, 30 in der Verbindung zwischen der Stromversorgung 14 und der Maschine 16 angeordnet sind. Die Maschine 16 kann den Arbeitsvorgang nur dann durchführen, wenn beide Schütze 24, 26 ihre jeweiligen Arbeitskontakte 28, 30 schließen.

In einer alternativen Ausführung, die hier schematisch angedeutet ist, muss zum Einschalten der Maschine 16 bei geschlossener Schutztür 20 noch ein Starttaster 19, der an der Steuereinheit 18 angeschlossen sein kann, betätigt werden.

Wenn eine der beiden Signalisiervorrichtungen 10 nicht mehr die Freigabe für die Anlage 16 anzeigt, beispielsweise weil die Schutztür 20 während des Betriebs geöffnet wurde, so lässt die Steuereinheit 18 die Schütze 24, 26 abfallen. Es ist auch denkbar, jeder der Signalisiervorrichtungen 10 einen Schütz 24, 26 zuzuordnen, so dass bei fehlender Freigabe von einer der Signalisiervorrichtungen 10 gezielt der zugeordnete Schütz 24, 26 abfällt. In jedem Fall wird die Maschine 16 dadurch stromlos.

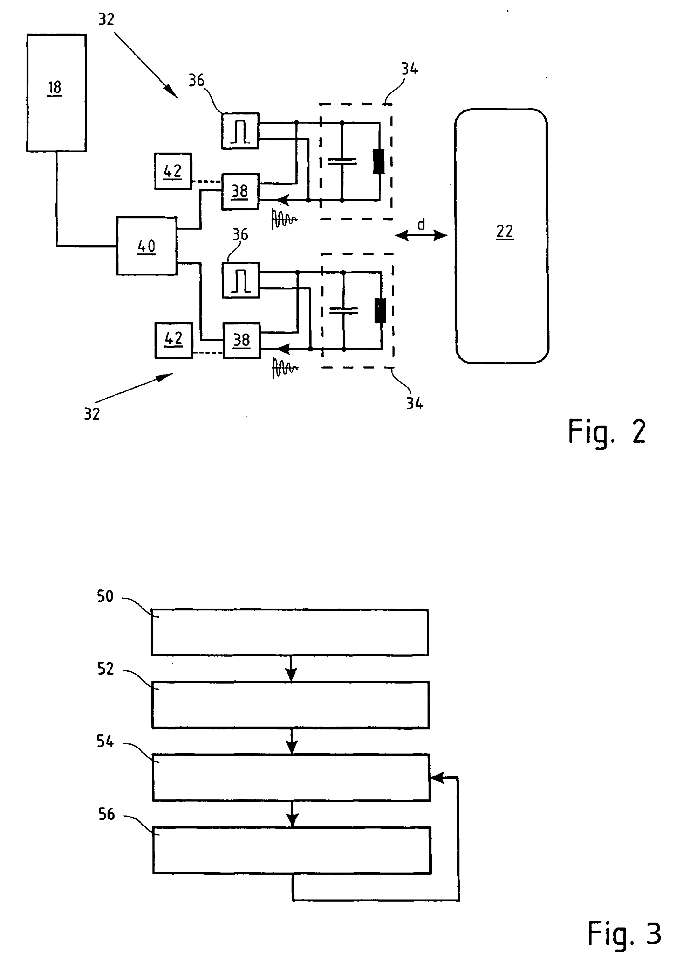

Figur 2 zeigt im Detail eine der Signalisiervorrichtungen 10, die hier redundant aufgebaut ist. Die Signalisiervorrichtung 10 weist dabei zwei im Wesentlichen baugleiche Module 32 auf, die jeweils einen Schwingkreis 34, einen Impulsgeber 36 und einen Signalgeber 38 aufweisen. Jeder Schwingkreis 34 weist bei diesem Ausführungsbeispiel einen Kondensator und eine Spule auf. Es sei darauf hingewiesen, dass der Impulsgeber 36 zur besseren Übersicht getrennt vom Signalgeber 38 gezeichnet ist, der Impulsgeber 36 aber auch mit dem Signalgeber 38 integriert sein kann.

Die Ausgänge der Signalgeber 38 sind an eine Vergleichseinheit 40 geführt, die zum Vergleichen der Signale der Signalgeber 38 und zum Signalisieren eines Fehlers bei fehlender Übereinstimmung der Signale ausgebildet ist. Das Ausgangssignal der Vergleichseinheit 40 ist zur Steuereinheit 18 geführt und wird dort ausgewertet. Ferner ist der Signalisiervorrichtung 10 ein metallisches Teil 22 aus einem ersten Material zugeordnet. Den Signalgebern 38 ist jeweils ein Speicher 42 zugeordnet, in dem Zusammenhänge zwischen der Frequenz und der Dämpfung bei Annäherung eines metallischen Teils 22 an die Signalisiervorrichtung 10 für verschiedene Materialien hinterlegt ist. Die gestrichelte Linie deutet an, dass der Speicher 42 optional ist.

Es sei darauf hingewiesen, die Signalisiervorrichtung 10 insbesondere zur Platzersparnis auch mit nur einem Schwingkreis 34 aufgebaut werden kann, der dann von beiden Vergleichseinheiten 40 abgegriffen wird.

Die Funktionsweise der Signalisiervorrichtung 10 soll zunächst anhand der Realisierung eines Manipulationsschutzes erläutert werden. Da die Module 32 die gleiche Funktionalität haben, bezieht sich die Erläuterung nun auf eines der Module 32.

Der Impulsgeber 36 sendet einen Impuls an den Schwingkreis 34. Durch den Impuls wird im Schwingkreis 34 eine abklingende Schwingung mit einer Ist-Frequenz und einer Ist-Dämpfung erzeugt. Die Ist-Frequenz und die Ist-Dämpfung sind dabei sowohl vom Abstand d zwischen dem metallischen Teil 22 und der Signalisiervorrichtung 10 als auch vom Material des metallischen Teils 22 abhängig.

Die Ist-Frequenz und die Ist-Dämpfung werden bestimmt und mit einer vorgegebenen Maximalfrequenz bzw. mit einer vorgegebenen Maximaldämpfung verglichen. Dafür kann der Signalgeber 38 eine entsprechende Mess- und Vergleichseinrichtung bereitstellen, die hier nicht näher dargestellt ist.

Unterschreitet sowohl die Ist-Frequenz die Maximalfrequenz als auch die Ist-Dämpfung die Maximaldämpfung, so generiert der Signalgeber 38 ein Freigabesignal, das an die Vergleichseinheit 40 geleitet wird.

Erhält die Vergleichseinheit 40 von beiden Modulen 32 ein Freigabesignal, so sendet sie ein Freigabesignal an die Steuereinheit 18. Sendet einer der beiden Signalgeber 38 kein Freigabesignal, so sendet auch die Vergleichseinheit 40 kein Freigabesignal. Dieses Verhalten sichert damit gleichzeitig den Fehlerfall ab, wenn die Signalgeber 38 unterschiedliche Signale senden.

Im hier gezeigten Ausführungsbeispiel überwacht die Signalisiervorrichtung 10 zudem, ob die Ist-Frequenz eine vorgegebene Minimalfrequenz und die Ist-Dämpfung eine vorgegebene Minimaldämpfung überschreitet. Ist dies nicht der Fall, sendet der Signalgeber 38 kein Freigabesignal.

Weitere Überwachungsmöglichkeiten, die sich unter Hinzuziehung des optionalen Speichers 42 ergeben, werden nachfolgend noch näher erläutert.

Figur 3 zeigt den Ablauf eines erfindungsgemäßen Verfahrens. Dabei wird in einem ersten Schritt 50 ein Schwingkreis 34 und in einem zweiten Schritt 52 ein metallisches Teil 22 aus einem ersten Material bereitgestellt. In einem Schritt 54 wird der Schwingkreis 34 dann mit einem Impuls angesteuert, so dass eine von einem Abstand d des metallischen Teils 22 zum Schwingkreis 34 abhängige, abklingende Schwingung mit einer Ist-Frequenz und einer Ist-Dämpfung entsteht. In einem Schritt 56 wird dann signalisiert, ob sowohl die Ist-Frequenz eine vorgegebene Maximalfrequenz als auch die Ist-Dämpfung eine vorgegebene Maximaldämpfung unterschreitet. Danach wird das Verfahren wieder mit dem Schritt 54 fortgesetzt.

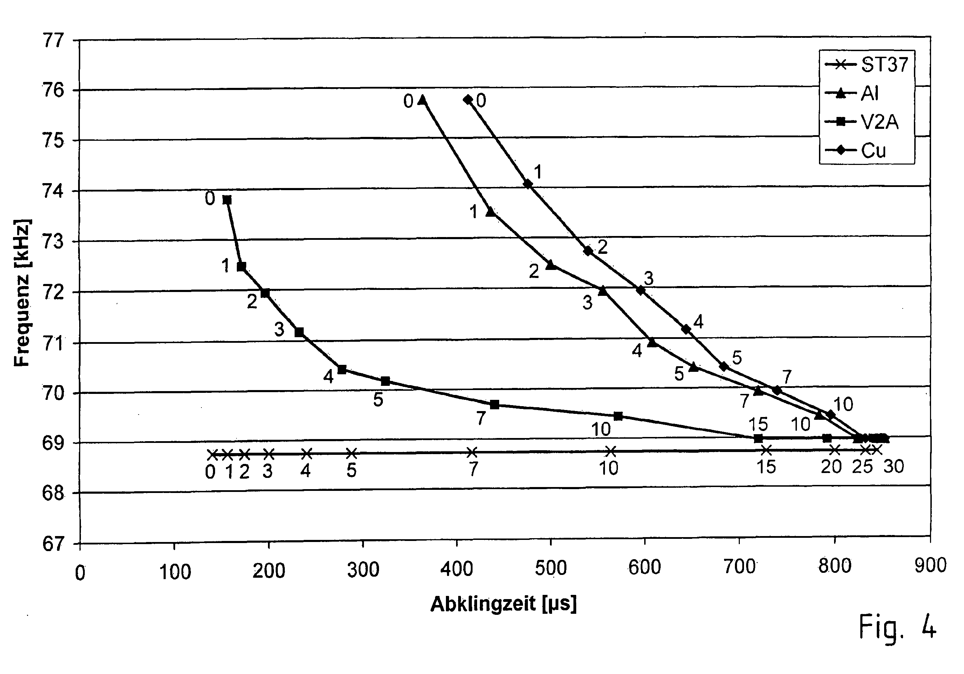

Figur 4 verdeutlicht die grundlegende Erkenntnis, die sich die Erfindung zur sicheren Abstandsüberwachung zu Nutze macht. Entlang der Abszisse ist eine Abklingzeit der im Schwingkreis 34 hervorgerufenen Schwingung dargestellt. Die Abklingzeit, ist die Zeit, die nach dem Senden des Impulses an den Schwingkreis 34 vergeht, bis sich die maximale Amplitude der Schwingung aufgrund der elektrischen Verluste auf einen bestimmten Prozentsatz, beispielsweise 10 %, verringert hat. Demnach stellt die Abklingzeit ein Maß für die Dämpfung dar. Je kleiner die Abklingzeit ist, desto größer ist die Dämpfung bzw. je größer die Abklingzeit ist, desto geringer ist die Dämpfung.

Entlang der Ordinate ist die Frequenz der Schwingung im Schwingkreis 34 abgetragen.

In der Figur 4 sind Zusammenhänge zwischen der Frequenz und der Dämpfung (Abklingzeit) für Eisenstahl (ST37), rostfreien Stahl (V2A), Aluminium (Al) und für Kupfer (Cu) dargestellt. Es wurde hier eine Kennliniendarstellung mit Stützwerten gewählt, wobei die Kennlinien aber auch durch einfache Funktionen, wie beispielsweise eine Geradenfunktion oder Expotentialfunktion, angenähert werden können.

Beispielhaft ist der Figur 4 zu entnehmen, dass bei einer Ist-Frequenz von ungefähr 72 kHz und einer Ist-Dämpfung repräsentiert durch eine Abklingzeit von ungefähr 200 µs der Rückschluss auf rostfreien Stahl im Abstand von 2 mm möglich ist oder bei einer Frequenz von ungefähr 74 kHz und einer Ist-Dämpfung repräsentiert durch eine Abklingzeit von ungefähr 475 µs auf ein metallisches Teil 22 aus Kupfer im Abstand von 1 mm geschlossen werden kann. Es ist also möglich, aus einem Zweier-Tupel von Ist-Frequenz und Ist-Dämpfung auf das Material des metallischen Teils 22 und/oder dessen Abstand d zum Schwingkreis 34 zu schließen.

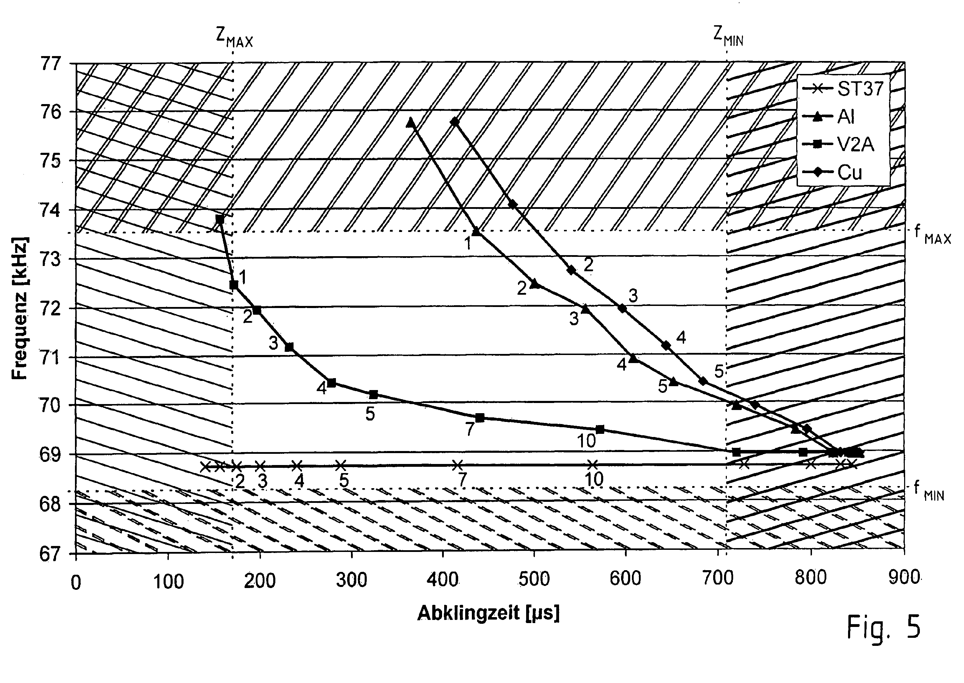

Figur 5 zeigt eine Ausführungsform, die auch ohne einen in einem Datensatz hinterlegten Zusammenhang zwischen der Frequenz und der Dämpfung einen einfachen und zuverlässigen Manipulationsschutz bietet.

Zur Verdeutlichung des Manipulationsschutzes wird zunächst auf die Maximalfrequenz F_{MAX} von ungefähr 73,5 kHz und auf die Maximaldämpfung Z_{MAX}, repräsentiert durch eine minimale Abklingzeit von ungefähr 175 µs, hingewiesen. Der Bereich, der die Maximalfrequenz f_{MAX} überschreitet, ist mittels einer Doppelschraffur dargestellt. Der Bereich, der die Maximaldämpfung Z_{MAX} überschreitet, ist mittels einer dünnen Einfachschraffur dargestellt.

Da sowohl die Ist-Frequenz als auch die Ist-Dämpfung der Schwingung im Schwingkreis 34 geprüft wird, bedeutet dies, dass kein Freigabesignal erzeugt wird, wenn sich ein beliebiges der in Frage kommenden Materialien im Abstand von weniger als 1 mm zum Schwingkreis 34 befindet.

Es sei an dieser Stelle ausdrücklich darauf hingewiesen, dass die Grafik für bestimmte Zweier-Tupel von Ist-Frequenz und Ist-Dämpfung eine Zuordnung zu einem Material und einem Abstandswert aufzeigt, dass aber eine Gewinnung oder eine Auswertung dieser Informationen für die Realisierung eines Manipulationsschutzes nicht erforderlich sind. Vielmehr ist eine Auswertung von Ist-Frequenz und Ist-Dämpfung bezüglich des jeweiligen Maximalwerts ausreichend, ohne dass eine Berücksichtigung des damit verbundenen Materials oder Abstands erforderlich ist.

Die Besonderheit des vorgeschlagenen Manipulationsschutzes liegt darin, dass er einfach zu realisieren ist und dennoch zuverlässig mit einer Vielzahl von verschiedenen Materialien, insbesondere ferromagnetischen und nicht-ferromagnetischen, zuverlässig funktioniert.

Es handelt sich dabei auch um eine flexible Lösung, da durch eine einfache Veränderung der Maximalfrequenz F_{MAX} und der Maximaldämpfung Z_{MAX} der vom Manipulationsschutz erfasste Bereich variiert werden kann. Wird beispielsweise die Maximalfrequenz f_{MAX} auf ungefähr 72,5 kHz und die Maximaldämpfung Z_{MAX} durch eine Abklingzeit von ungefähr 190 µs vorgegeben, so wird für alle in Frage kommenden Metalle ein Mindestabstand von ungefähr 2 mm definiert.

Die Überwachung eines maximalen Abstands kann in ähnlicher Weise erfolgen. Dazu wird eine Minimaldämpfung Z_{MIN} in der Form einer maximalen Abklingzeit vorgegeben. Der durch diese Vorgabe ausgeschlossene Bereich ist mittels einer dicken Einfachschraffur dargestellt. Falls es erforderlich sein sollte, kann auch eine Minimalfrequenz f_{MIN} definiert werden. Der daraus resultierende Bereich ist mittels der doppelten gestrichelten Schraffur dargestellt.

Selbstverständlich kann aber auch bei dieser Ausführungsform, wenn im Speicher 42 die entsprechenden Zusammenhänge hinterlegt sind, eine Aussage über das Material und/oder den Abstand getroffen werden. Es sei aber erneut darauf hingewiesen, dass sowohl der für einen Manipulationsschutz notwendige Mindestabstand als auch der maximal zulässige Abstand allein durch einen Vergleich der Ist-Frequenz und der Ist-Dämpfung mit jeweils zugeordneten Minimal/ Maximalwerten realisiert werden können.

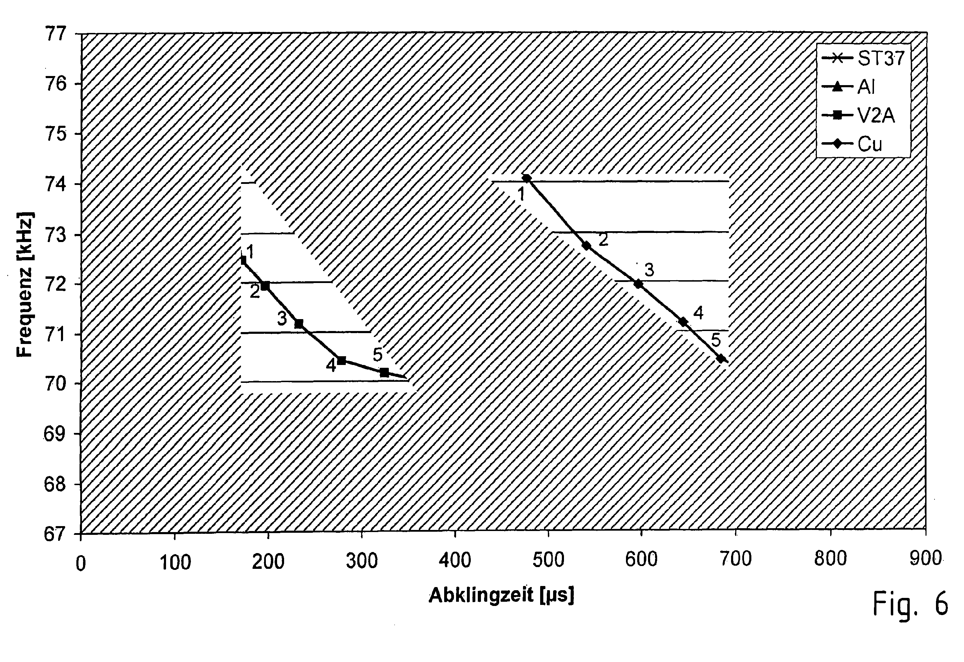

Figur 6 zeigt eine Ausführungsform, bei der nur spezifische Materialien mit spezifischen Abständen erlaubt sind, um ein Freigabesignal zu erhalten. Bei dieser Ausführungsform sind in einem Datensatz die Zusammenhänge für ausgewählte Materialien hinterlegt, wobei durch einen entsprechenden Prüfalgorithmus bestimmte Bereiche als zulässig (nicht-schraffiert) und andere Bereiche als unzulässig (schraffiert) definiert sind. Dabei wurden in diesem Beispiel die Einstellungen derart vorgenommen, dass bei Annäherung eines metallischen Teils 22 aus rostfreiem Stahl oder aus Kupfer im Bereich von ungefähr 1 mm bis 5 mm ein Freigabesignal erteilt wird, während in anderen Abstandsbereichen oder für andere Materialien kein Freigabesignal gesendet wird. Aufgrund der im Datensatz hinterlegten Daten ist es außerdem möglich, jeweils das erkannte Material und den Abstandswert anzugeben.

Aufgrund des bekannten Zusammenhangs zwischen der Frequenz und der Dämpfung, die rechnerisch und/oder experimentell ermittelt werden kann, kann aber auch hier auf eine Hinterlegung von Materialinformationen und/oder Abstandsinformationen verzichtet werden, da eine Abfrage, ob sich ein bestimmtes Zweier-Tupel von Ist-Frequenz und Ist-Dämpfung in einem zulässigen Bereich befindet, ausreichend ist.

Selbstverständlich können auch komplexere Formen zur Beschreibung der zulässigen bzw. unzulässigen Bereiche verwendet werden oder werden lediglich Abschnitte von Kennlinien hinterlegt. Die Bereiche können insbesondere auch als Funktionen durch Formeln beschrieben und mit einem Toleranzband versehen werden.

Insgesamt zeigt die Erfindung eine einfache und zuverlässige Möglichkeit auf, eine Signalisiervorrichtung mit einem Manipulationsschutz aufzubauen und zu betreiben. Des Weiteren ermöglicht die Erfindung eine umfangreiche Definition von zulässigen bzw. unzulässigen Zuständen, das heißt solche Zustände, bei denen ein Freigabesignal bzw. kein Freigabesignal erzeugt wird, zu definieren. Es ist dabei sowohl möglich, für verschiedene Materialien auf einfache Weise einen gleichen Mindestabstand zu definieren, aber auch für bestimmte Materialien vorzusehen, dass bei keinem Abstandswert ein Freigabesignal erzeugt wird. Es besteht sowohl die Möglichkeit, bestimmte Materialien in die Erkennung explizit einzubeziehen als auch explizit auszuschließen. Somit bietet die Erfindung neben der einfachen Umsetzung der grundlegenden Idee auch eine Basis für die Umsetzung anspruchsvoller Anforderungen.

## Patentansprüche

1. Verfahren zum sicheren Überwachen eines Abstands (d) eines metallischen Teils (22) relativ zu einem induktiven Näherungssensor, insbesondere zum Überwachen einer Schließposition einer Schutztür (20) an einer automatisierten Anlage (16), mit den folgenden Schritten:
- Bereitstellen eines Schwingkreises (34),
- Bereitstellen eines metallischen Teils (22) aus einem ersten Material,
- Ansteuern des Schwingkreises (34) mit mindestens einem Impuls, so dass eine von einem Abstand (d) des metallischen Teils (22) zum Schwingkreis (34) abhängige, abklingende Schwingung mit einer Ist-Frequenz und einer Ist-Dämpfung entsteht, und
- Signalisieren, ob sowohl die Ist-Frequenz eine vorgegebene Maximalfrequenz (f_{MAX}) als auch die Ist-Dämpfung eine vorgegebene Maximaldämpfung (Z_{MAX}) unterschreitet und ob die Ist-Frequenz eine vorgegebene Minimalfrequenz (f_{MIN}) und/oder die Ist-Dämpfung eine vorgegebene Minimaldämpfung (Z_{MIN}) überschreitet.

2. Verfahren nach Anspruch 1, **dadurch gekennzeichnet, dass** ein Datensatz bereit gestellt wird, der einen ersten Zusammenhang zwischen der Frequenz und der Dämpfung bei Annäherung des metallischen Teils (22) repräsentiert und das Signalisieren anzeigt, ob die Ist-Frequenz und die Ist-Dämpfung dem ersten Zusammenhang entsprechen.

3. Verfahren nach Anspruch 2, **dadurch gekennzeichnet, dass** der Datensatz einen von Frequenz und Dämpfung abhängigen Abstand zwischen dem metallischen Teil (22) und dem Schwingkreis (34) beschreibt und ein Abstandswert in Abhängigkeit von Ist-Frequenz und Ist-Dämpfung bestimmt wird.

4. Verfahren nach Anspruch 3, **dadurch gekennzeichnet, dass** signalisiert wird, ob der Abstandswert einen Mindestabstandswert überschreitet und/oder einen Maximalabstandswert unterschreitet.

5. Verfahren nach einem der Ansprüche 2 bis 4, **dadurch gekennzeichnet, dass** der Datensatz einen zweiten Zusammenhang zwischen der Frequenz und der Dämpfung bei Annäherung eines metallischen Teils (22) aus einem vom ersten Material verschiedenen, zweiten Material an den Schwingkreis (34) repräsentiert und dass signalisiert wird, ob die Ist-Frequenz und die Ist-Dämpfung dem zweiten Zusammenhang entsprechen.

6. Verfahren nach Anspruch 5, **dadurch gekennzeichnet, dass** signalisiert wird, welchem der im Datensatz hinterlegten Zusammenhänge die Ist-Frequenz und die Ist-Dämpfung entsprechen.

7. Verfahren nach Anspruch 5 oder 6, **dadurch gekennzeichnet, dass** im Datensatz mindestens ein weiterer Zusammenhang für ein weiteres Material hinterlegt ist und signalisiert wird, ob die Ist-Frequenz und die Ist-Dämpfung einem Zusammenhang aus einer bestimmten Gruppe von Zusammenhängen entsprechen.

8. Verfahren nach einem der Ansprüche 1 bis 7, **dadurch gekennzeichnet, dass** das Verfahren doppelt ausgeführt wird und dass bei einem Abweichen in der jeweils resultierenden Signalisierung ein Fehler signalisiert wird.

9. Signalisiervorrichtung (10) zum sicheren Überwachen eines Abstands eines metallischen Teils (22) relativ zu einem induktiven Näherungssensor, insbesondere zum Überwachen einer Schließposition einer Schutztür (20) an einer automatisierten Anlage (16), mit einem Schwingkreis (34), einem zugeordneten metallischen Teil (22) aus einem ersten Material und einem Impulsgeber (36) zum Ansteuern des Schwingkreises (34) mit mindestens einem Impuls zur Erzeugung einer von einem Abstand des metallischen Teils (22) zum Schwingkreis (34) abhängigen, abklingenden Schwingung mit einer Ist-Frequenz und einer Ist-Dämpfung, sowie ferner mit einem Signalgeber (38), der zum Signalisieren einer Unterschreitung sowohl der Ist-Frequenz bezogen auf eine vorgegebene Maximalfrequenz (f_{MAX}) als auch der Ist-Dämpfung bezogen auf eine vorgegebene Maximaldämpfung (Z_{MAX}) und einer Überschreitung der Ist-Frequenz bezogen auf eine vorgegebene Minimalfrequenz und/oder der Ist-Dämpfung bezogen auf eine vorgegebene Minimaldämpfung ausgebildet ist.

10. Signalisiervorrichtung (10) nach Anspruch 9, **gekennzeichnet durch** einen Speicher (42), in dem ein erster Zusammenhang zwischen der Frequenz und der Dämpfung bei Annäherung des metallischen Teils (22) hinterlegt ist und der Signalgeber (38) dafür ausgebildet ist zu signalisieren, ob die Ist-Frequenz und die Ist-Dämpfung dem ersten Zusammenhang entsprechen.

11. Signalisiervorrichtung (10) nach Anspruch 9 oder 10, **dadurch gekennzeichnet, dass** die Signalisiervorrichtung (10) mittels eines weiteren Schwingkreises (34) und einem weiteren Signalgeber (38) redundant aufgebaut ist und eine Vergleichseinheit (40) zum Vergleichen der Signale der Signalgeber (38) und zum Signalisieren eines Fehlers bei fehlender Übereinstimmung aufweist.

## Claims

1. A method for failsafely monitoring a distance (d) of a metallic part (22) relative to an inductive proximity sensor, in particular for monitoring a closed position of a guard door (20) in an automated system (16), said method comprising the following steps:
- providing an oscillating circuit (34),
- providing a metallic part (22) made of a first material,
- driving the oscillating circuit (34) with at least one pulse, such that a decaying oscillation is generated which is dependent on a distance (d) between the metallic part (22) and the oscillating circuit (34) and which has an actual frequency and an actual attenuation, and
- signaling whether both the actual frequency undershoots a predefined maximum frequency (F_{MAX}) and the actual attenuation undershoots a predefined maximum attenuation (Z_{MAX}), and whether the actual frequency exceeds a predefined minimum frequency (f_{MIN}) and/or the actual attenuation exceeds a predefined minimum attenuation (Z_{MIN}).

2. The method as claimed in claim 1, **characterized in that** a data record is provided which represents a first correlation between the frequency and the attenuation as the metallic part (22) approaches, and the signaling indicates whether the actual frequency and the actual attenuation correspond to the first correlation.

3. The method as claimed in claim 2, **characterized in that** the data record describes a distance between the metallic part (22) and the oscillating circuit (34), which distance is dependent on the frequency and attenuation, and a distance value is determined on the basis of the actual frequency and the actual attenuation.

4. The method as claimed in claim 3, **characterized in that** it is signaled whether the distance value exceeds a minimum distance value and/or undershoots a maximum distance value.

5. The method as claimed in one of claims 2 to 4, **characterized in that** the data record represents a second correlation between the frequency and the attenuation when a metallic part (22) made of a second material that is different from the first material approaches the oscillating circuit (34), and **in that** it is signaled whether the actual frequency and the actual attenuation correspond to the second correlation.

6. The method as claimed in claim 5, **characterized in that** it is signaled to which of the correlations stored in the data record the actual frequency and the actual attenuation correspond.

7. The method as claimed in claim 5 or 6, **characterized in that** the data record stores at least one further correlation for a further material, and it is signaled whether the actual frequency and the actual attenuation correspond to a correlation from a particular group of correlations.

8. The method as claimed in one of claims 1 to 7, **characterized in that** the method is carried out twice, and **in that** a fault is signaled if there is a difference in the respective resultant signaling.

9. A signaling device (10) for failsafely monitoring a distance of a metallic part (22) relative to an inductive proximity sensor, in particular for monitoring a closed position of a guard door (20) in an automated system (16), said device comprising an oscillating circuit (34), an associated metallic part (22) made of a first material and a pulse generator (36) for driving the oscillating circuit (34) with at least one pulse in order to generate a decaying oscillation which is dependent on a distance between the metallic part (22) and the oscillating circuit (34) and which has an actual frequency and an actual attenuation, and also comprising a signal transmitter (38) which is adapted to signal when both the actual frequency undershoots a predefined maximum frequency (f_{MAX}) and the actual attenuation undershoots a predefined maximum attenuation (Z_{MAX}) and when the actual frequency exceeds a predefined minimum frequency (f_{MIN}) and/or the actual attenuation exceeds a predefined minimum attenuation (Z_{MIN}).

10. The signaling device (10) as claimed in claim 9, **characterized by** a memory (42) which stores a first correlation between the frequency and the attenuation as the metallic part (22) approaches, and the signal transmitter (38) is designed to signal whether the actual frequency and the actual attenuation correspond to the first correlation.

11. The signaling device (10) as claimed in claim 9 or 10, **characterized in that** the signaling device (10) is of redundant design by means of a further oscillating circuit (34) and a further signal transmitter (38) and has a comparison unit (40) for comparing the signals from the signal transmitters (38) and for signaling a fault if said signals do not match.

## Revendications

1. Procédé de surveillance sûre de la distance (d) entre une pièce métallique (22) et un détecteur inductif d'approche, en particulier pour surveiller la position de fermeture d'une porte de protection (20) d'une installation automatique (16), le procédé présentant les étapes suivantes :
- prévoir un circuit oscillant (34),
- prévoir une pièce métallique (22) en un premier matériau,
- commander le circuit oscillant (34) par au moins une impulsion de manière à susciter une oscillation amortie d'une fréquence effective et d'un amortissement effectif qui dépendent de la distance (d) entre la pièce métallique (22) et le circuit oscillant (34) et
- signaler si la fréquence effective n'atteint pas une fréquence maximale (f_{MAX}) prédéterminée et si l'amortissement effectif n'atteint pas un amortissement maximum prédéterminé (Z_{MAX}) et si la fréquence effective dépasse une fréquence minimale (f_{MIN}) prédéterminée et/ou si l'amortissement effectif dépasse un amortissement minimum (Z_{MIN}) prédéterminé.

2. Procédé selon la revendication 1, **caractérisé en ce qu'**il est prévu un jeu de données qui représente une première relation entre la fréquence et l'amortissement lorsque la pièce métallique (22) s'approche et **en ce que** la signalisation indique si la fréquence effective et l'amortissement effectif correspondent à la première relation.

3. Procédé selon la revendication 2, **caractérisé en ce que** le jeu de données décrit une distance, qui dépend de la fréquence et de l'amortissement, entre la pièce métallique (22) et le circuit oscillant (34) et **en ce qu'**une valeur de distance est définie en fonction de la fréquence effective et de l'amortissement effectif.

4. Procédé selon la revendication 3, **caractérisé en ce qu'**il est signalé si la valeur de distance dépasse une valeur minimale de distance et/ou n'atteint pas une valeur maximale de distance.

5. Procédé selon l'une des revendications 2 à 4, **caractérisé en ce que** le jeu de données représente une deuxième relation entre la fréquence et l'amortissement lorsqu'une pièce métallique (22) en un deuxième matériau, différent du premier matériau, s'approche du circuit oscillant (34) et **en ce qu'**il est signalé si la fréquence effective et l'amortissement effectif correspondent à la deuxième relation.

6. Procédé selon la revendication 5, **caractérisé en ce qu'**il est signalé à laquelle des relations conservées dans le jeu de données la fréquence effective et l'amortissement effectif correspondent.

7. Procédé selon la revendication 5 ou 6, **caractérisé en ce que** le jeu de données contient au moins une autre relation pour un autre matériau et **en ce qu'**il est signalé si la fréquence effective et l'amortissement effectif correspondent à une relation contenue dans un ensemble défini de relations.

8. Procédé selon l'une des revendications 1 à 7, **caractérisé en ce que** le procédé est exécuté deux fois et **en ce qu'**en cas d'écart entre les signalisations obtenues dans chaque cas, une erreur est signalée.

9. Dispositif de signalisation (10) pour la surveillance sûre de la distance entre une pièce métallique (22) et un détecteur inductif d'approche, en particulier pour la surveillance de la position de fermeture d'une porte de protection (20) d'une installation automatique (16), présentant un circuit oscillant (34) auquel est associée une pièce métallique (22) en un premier matériau et un émetteur d'impulsions (36) qui commande le circuit oscillant (34) à l'aide d'au moins une impulsion, pour former une oscillation amortie d'une fréquence effective et d'un amortissement effectif qui dépendent de la distance entre la pièce métallique (22) et le circuit oscillant (34), et doté en outre d'un émetteur (38) de signaux qui est configuré pour signaliser si la fréquence effective est inférieure à une fréquence maximale (f_{MAX}) prédéterminée et si l'amortissement effectif est inférieur à un amortissement maximum (Z_{MAX}) prédéterminé et si la fréquence effective dépasse une fréquence minimum prédéterminée et/ou si l'amortissement effectif dépasse un amortissement minimum prédéterminé.

10. Dispositif de signalisation (10) selon la revendication 9, **caractérisé par** une mémoire (42) dans laquelle une première relation entre la fréquence et l'amortissement lorsque la pièce métallique (22) s'approche est conservée, l'émetteur (38) de signaux étant configuré pour signaler si la fréquence effective et l'amortissement effectif correspondent à la première relation.

11. Dispositif de signalisation (10) selon la revendication 9 ou 10, **caractérisé en ce que** le dispositif de signalisation (10) a une structure redondante grâce à un deuxième circuit oscillant (34) et un autre émetteur (38) de signaux et présente une unité de comparaison (40) qui compare les signaux des émetteurs (38) de signaux et qui signale une erreur en cas d'absence de correspondance.
